# EUROPEAN PATENT SPECIFICATION

(11) **EP 2 931 801 B1**
(45) Date of publication and mention of the grant of the patent: **21.11.2018**
(21) Application number: 13827036.8
(22) Date of filing: 27.11.2013
(51) Int. Cl.: C08K 3/22

(54) **THERMALLY CONDUCTIVE FLAME RETARDANT POLYMER COMPOSITIONS AND USES THEREOF**
WÄRMELEITENDE FLAMMHEMMENDE POLYMERZUSAMMENSETZUNGEN UND VERWENDUNGEN DAVON
COMPOSITIONS DE POLYMÈRE IGNIFUGES THERMOCONDUCTRICES ET LEURS UTILISATIONS

(30) Priority: 14.12.2012 US 201261737539 P
(43) Date of publication of application: 21.10.2015
(73) Proprietor: SABIC Global Technologies B.V., 4612 PX Bergen op Zoom (NL)
(72) Inventor: MERCX, Franciscus Petrus Maria, NL-4612 PX Bergen op Zoom (NL); TER HORST, Sascha, NL-4612 PX Bergen op Zoom (NL)
(74) Representative: Chevalier, Renaud Philippe
(86) International application number: PCT/IB2013/060454
(87) International publication number: WO 2014/091350

(56) References cited:
- WO-A1-2011/010290
- WO-A1-2014/036720
- US-A1- 2012 202 061
- DATABASE WPI Week 199742 Thomson Scientific, London, GB; AN 1997-454104 XP002723677, -& JP H09 208841 A (ASAHI KASEI KOGYO KK) 12 August 1997 (1997-08-12)
- DATABASE WPI Week 200838 Thomson Scientific, London, GB; AN 2008-G03228 XP002723617, -& WO 2008/044471 A1 (NEC CORP) 17 April 2008 (2008-04-17)

## Description

### BACKGROUND

This disclosure relates to a thermally conductive flame retardant polymer composition. The present invention also relates to methods of manufacturing these compositions and articles that comprise these compositions.

Thermoplastic polymer compositions are used for various applications, such as in housings for personnel computers, display devices, electronic device materials, automotive exterior and interior parts, and the like. It is desirable for polymers used in the aforementioned applications to be flame retardant and also to be thermally conductive to dissipate and distribute heat away from heat sensitive portions of the device.

Flame retardant additives are often added to thermoplastic polymer compositions to improve the flame retardancy of the composition. However, the addition of certain flame retardant additives often reduces the thermal conductivity and/or the impact strength of the composition. It is therefore desirable to add compounds that improve the flame retardancy while simultaneously improving the thermal conductivity of the composition.

Since polymer compositions are less thermally conductive than metals, any heat generated in these materials is not easily dissipated to the surrounding. In order to compensate for this deficiency, thermally conducting fillers are added to the thermoplastic polymer compositions. High volume fractions of filler are used to achieve thermal conductivities suitable for efficient heat transport through the thermoplastic polymer composition. Ceramic fillers are often added to the thermoplastic polymer compositions in order to increase the thermal conductivity. The number of ceramic filler types that can currently be used for thermally conductive compositions is relatively limited, since most ceramic fillers are thermally insulating or have a relatively low thermal conductivity. Consequently, ceramic fillers with a high thermal conductivity are expensive to use and the design freedom to control other properties, such as mechanical properties, flow and heat stability, is limited. It is therefore desirable to use improved fillers or combinations thereof that achieve thermally conductive compositions that are inexpensive and that produce flame retardancy when desired.

### SUMMARY

Disclosed herein is a thermally conductive composition, comprising 20 to 80 wt% of a thermoplastic or thermosetting polymer; 10 to 70 wt% of a metal hydroxide; and a polymeric char forming agent, where the polymeric char forming agent is a poly(arylene ether), a polyetherimide, a polyetherimide/polyimide copolymer, a polycarbonate, a polysulfone, a polyethersulfone, a polyetheretherketone, a polyetherketone, a polyketone, or a combination comprising at least one of the foregoing polymeric char forming agents, where the polymeric char forming agent provides the thermally conductive composition with a flame retardancy of V-0 at a thickness of 1.5 millimeter or less when tested as per a UL-94 testing protocol.

Disclosed herein too is a method comprising blending 20 to 80 wt% of a thermoplastic or thermosetting polymer; 10 to 70 wt% of a metal hydroxide; and 0.5 to 10 wt% of a polymeric char-forming agent, where the polymeric char forming agent is a poly(arylene ether), a polyetherimide, a polyetherimide/polyimide copolymer, a polycarbonate a polysulfone, a polyethersulfone, a polyetheretherketone, a polyetherketone, a polyketone, or a combination comprising at least one of the foregoing polymeric char forming agents, wherein the thermally conductive composition has a thermal conductivity of at least 0.5 W/mK for through plane thermal conductivity; and a flame retardancy of at least V-0 performance at a thickness of 1.5 mm or less when tested as per a UL94 testing standard.

### DETAILED DESCRIPTION

Disclosed herein is a thermally conductive composition having improved flame retardant behavior as well as methods of making these compositions and the articles made therefrom. In one embodiment, the thermally conductive compositions comprise a thermoplastic resin, a metal hydroxide, a polymer-based char-forming agent or a combination thereof, optionally fillers or reinforcing agents capable of providing thermal conductivity characteristics and optionally other pigments and/or processing additives. The reinforcing fillers may be thermally conductive but providing thermal conductivity to the composition is optional. The thermally conductive compositions can be used in a variety of applications such as heat or thermal dissipation management applications where electrical insulation is desired. In an alternative embodiment, thermally conductive compositions can be used in a variety of applications such as heat or thermal dissipation management applications where electrical conductivity is desired. In other words, the composition can be electrically conducting or electrically insulating, while at the same time being thermally conducting as well as flame retardant. Examples include heat sinks for electronic components in computers and consumer electrical appliances, solar cells and batteries such as processors, lamps, LED-lamps, electric motors, electric circuits, the encapsulation of electronics, such as coils or casings, solar cell back sheets, battery casings, or the manufacture of heat exchangers for highly problematic (corrosive) environments.

In an embodiment, the thermoplastic polymer used in the thermally conductive compositions is an organic polymer. In this embodiment, the organic polymer is selected from a wide variety of thermoplastic resins, thermosetting resins, blends of thermoplastic resins or blends of thermosetting resins. The thermoplastic polymer may also comprise blends of one or more thermoplastic resins with one or more thermosetting resins. The thermoplastic polymer can also be a blend of polymers, copolymers, terpolymers, or a combination comprising at least one of the foregoing organic polymers. Examples of the organic polymer are polyethylene (PE), including high-density polyethylene (HDPE), linear low-density polyethylene (LLDPE), low-density polyethylene (LDPE), mid-density polyethylene (MDPE), glycidyl methacrylate modified polyethylene, maleic anhydride functionalized polyethylene, maleic anhydride functionalized elastomeric ethylene copolymers (like EXXELOR® VA1801 and VA1803 from ExxonMobil), ethylene-butene copolymers, ethylene-octene copolymers, ethylene-acrylate copolymers, such as ethylene-methyl acrylate, ethylene-ethyl acrylate, and ethylene butyl acrylate copolymers, glycidyl methacrylate functionalized ethylene-acrylate terpolymers, anhydride functionalized ethylene-acrylate polymers, anhydride functionalized ethylene-octene and anhydride functionalized ethylene-butene copolymers, polypropylene (PP), maleic anhydride functionalized polypropylene, glycidyl methacrylate modified polypropylene, polyacetals, (meth)acryl polymers (which as used herein includes polymers of acrylic acid, methacrylic acid, (C1-C6)alkyl acrylates, (C1-C6)alkyl methacrylates, and copolymers comprising a least one of the foregoing), polycarbonates, polystyrenes, polyesters, polyamides, polyamideimides, polyarylates, polytetrafluoroethylenes, polypiperazines, polycarboranes, polyoxabicyclononanes, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfonamides, polyureas, polyphosphazenes, polysilazanes, polyurethanes, or the like, or a combination comprising at least one of the foregoing organic polymers.

Thermosetting polymers may also be used. Examples of thermosetting polymers are epoxy polymers, unsaturated polyester polymers, polyimide polymers, bismaleimide polymers, bismaleimide triazine polymers, cyanate ester polymers, vinyl polymers, benzoxazine polymers, benzocyclobutene polymers, acrylics, alkyds, phenol-formaldehyde polymers, novolacs, resoles, melamine-formaldehyde polymers, urea-formaldehyde polymers, hydroxymethylfurans, isocyanates, diallyl phthalate, triallyl cyanurate, triallyl isocyanurate, unsaturated polyesterimides, or the like, or a combination comprising at least one of the foregoing thermosetting polymers.

In an exemplary embodiment, the organic polymer that can be used in the thermally conductive composition is a polyamide, a polyester, and a polyolefin.

Accordingly, in one embodiment, an organic polymer that can be used in the conductive composition is a polyamide. The polyamide resins comprise a generic family of resins known as nylons, characterized by the presence of an amide group (--C(O)NH--). Any amide-containing polymers can be employed, individually or in combination. Nylon-6 and nylon-6,6 are suitable polyamide resins available from a variety of commercial sources. Other polyamides, however, such as nylon-4, nylon-4,6 (PA 46), nylon-12, nylon-6,10, nylon-6,9, nylon-6,12, nylon-9T, copolymer of nylon-6,6 and nylon-6, nylon 610 (PA610), nylon 11 (PA11), nylon 12 (PA 12), nylon 6-3-T (PA 6-3-T), polyarylamid (PA MXD 6), polyphthalamide (PPA) and/or poly-ether-block amide, and others such as the amorphous nylons, may also be useful. Mixtures of various polyamides, as well as various polyamide copolymers, are also useful.

The organic polymer is present in the thermally conductive composition in an amount of 10 to 70 wt% (weight percent), specifically 20 to 60 wt%, and more specifically 30 to 50 wt%, based on the total weight of the thermally conductive composition. In an exemplary embodiment, the thermally conductive composition comprises 30 to 45 wt%, based on the total weight of the thermally conductive composition.

The metal hydroxide is used to improve flame retardancy of the thermally conductive composition. The metal hydroxide can therefore be regarded as being the flame retardant package or as being part of a flame retardant package. The metal hydroxide generally releases water upon being heated and the water reduces the flammability of the composition. In one embodiment, the metal hydroxide may comprise Mg(OH)₂ (magnesium hydroxide), γ-AlO(OH) (boehmite), α-AlO(OH) (diaspore), Al(OH)₃ (gibbsite), calcium hydroxide, or the like, or a combination comprising at least one of the foregoing metal hydroxides.

The metal hydroxide may be present in the thermally conductive composition in an amount of 10 to 70 wt%, specifically 15 to 68 wt%, more specifically 20 to 65 wt%, and more specifically 40 to 60 wt%, based on the total weight of the thermally conductive composition.

In one embodiment, the thermally conductive composition comprises an aromatic polymer as a polymeric char-forming agent. The aromatic polymer forms a polymer char upon being subjected to a flame. The polymeric char forms structural reinforcement in the thermally conductive composition when it is subjected to a flame, which prevents the thermally conductive composition from dripping. The polymeric char acts synergistically with the metal hydroxide to improve flame retardancy. In one embodiment, the combination of the polymer char forming agent and the metal hydroxide imparts a flame retardancy of V-0 at a sample thickness of 1.5 millimeter or less to the thermally conductive composition.

The polymeric char-forming agent may comprise poly(arylene ether)s, polyetherimides, polycarbonates, polysulfones, polyethersulfones, polyaryletherketones (PAEK), polyarylates (PAR), polybenzothiazoles, aromatic impact modifiers, or the like, or a combination comprising at least one of the foregoing aromatic polymers. The aromatic polymer that acts to form a polymeric char may be present in the thermally conductive composition in an amount of 0.5 to 40 wt%, specifically 1.5 to 30 wt%, more specifically 2.0 to 25 wt%, and yet more specifically 2.5 to 10 wt%, based on the total weight of the thermally conductive composition.

In some instances it might be advantageous to pre-compatibilize the char-forming agent with the resin as this ensures a better and more homogeneous distribution of the char former in the final composition.

In another embodiment, the polymeric char-forming agent comprises aromatic impact modifiers. The aromatic impact modifiers may be styrene block copolymers. The impact modifiers may be used to improve the impact strength of the thermally conductive composition, while at the same time functioning to form a polymeric char when the composition is subjected to a flame.

The styrene block copolymers may be a linear block copolymer or a radial block copolymer, and may be of the di-block or tri-block variety. Exemplary styrenic impact modifiers are styrene block copolymers including styrene-butadiene-styrene copolymer (SBS), styrene-(ethylene-butene)-styrene (SEBS), styrene butadiene rubbers (SBR), acrylonitrile-butadiene-styrene copolymers (ABS), styrenemaleic anhydride (SMA) copolymers, alkyl methacrylate styrene acrylonitrile (AMSAN), methylmethacrylate-butadiene-styrene (MBS), or the like, or a combination comprising at least one of the foregoing impact modifiers. Other suitable impact modifiers include styrene-(ethylene-propylene)-styrene (SEPS), styrene-(ethylene-butene) (SEB), styrene-(ethylene-propylene) (SEP), styrene-isoprene-styrene (SIS), styrene-isoprene, styrene-butadiene, α-methylstyrene-isoprene-α-methylstyrene, α-methylstyrene-butadiene-α-methylstyrene, as well as hydrogenated versions of these block copolymers. Commercially available styrene block copolymers include KRATON available from Shell and K-RESIN available from Chevron Phillips Chemical Company.

The amount of impact modifier present in the thermally conductive composition may be up to 20 wt%, more specifically 5 to 15 wt%, or even more specifically 8 to 10 wt%, based on the total weight of the thermally conductive composition. The thermally conductive composition can contain as low as 1 wt% of the impact modifier.

The thermally conductive composition may also contain a fluorinated anti-drip agent. Fluorinated polyolefin and/or polytetrafluoroethylene may be used as an anti-drip agent. Anti-drip agents may also include a fibril forming or non-fibril forming fluoropolymer such as polytetrafluoroethylene (PTFE). The anti-drip agent may be encapsulated by a rigid copolymer such as, for example styrene acrylonitrile (SAN), PTFE encapsulated in SAN is known as TSAN. Encapsulated fluoropolymers may be made by polymerizing the encapsulating polymer in the presence of the fluoropolymer, for example, in an aqueous dispersion. TSAN may provide significant advantages over PTFE, in that TSAN may be more readily dispersed in the composition. A suitable TSAN may comprise, for example, about 50 wt % PTFE and about 50 wt % SAN, based on the total weight of the encapsulated fluoropolymer. The SAN may comprise, for example, about 75 wt % styrene and about 25 wt % acrylonitrile based on the total weight of the copolymer. Alternatively, the fluoropolymer may be pre-blended in some manner with a second polymer, such as for, example, an aromatic polycarbonate resin or SAN to form an agglomerated material for use as an anti-drip agent. Either method may be used to produce an encapsulated fluoropolymer.

Fillers and reinforcing agents may be added to the thermally conductive composition to improve the thermal conductivity of the composition. The thermally conductive composition can have a thermal conductivity of 0.5 to 7 W/mK in through-plane direction when measured as per ISO-22007-2 at a thickness of 3mm.

The fillers may have a thermal conductivity that varies from 1 to 2500 Watts per meter Kelvin (W/mK) and an electrical conductivity that varies from being insulating (i.e., having an electrical resistivity that is greater than or equal to 10⁵ Ohm.cm) to being electrically conducting (i.e., having an electrical conductivity that is less than or equal to 1 Ohm.cm). These are detailed below.

In one embodiment, the thermally conductive composition comprises optionally added fillers and reinforcing agents that have low thermal conductivity. In other words, low thermally conductive, electrically insulating fillers can be added to the thermally conductive composition. The low thermally conductive, electrically insulative filler has an intrinsic thermal conductivity of 10 to 30 W/mK and, in one embodiment, has an electrical resistivity greater than or equal to 10⁵ Ohm.cm. Examples of the low thermally conductive filler are ZnS (zinc sulfide), CaO (calcium oxide), MgO (magnesium oxide), ZnO (zinc oxide), or TiO₂ (titanium dioxide), or the like, or a combination comprising at least one of the foregoing low thermally conductive, electrically insulating fillers.

In one embodiment, one or more high thermally conductive, electrically insulating fillers can be used. The high thermally conductive filler has an intrinsic thermal conductivity greater than or equal to 50 W/mK and, in one embodiment, has an electrical resistivity greater than or equal to 10⁵ Ohm.cm. Examples of the high thermally conductive, electrically insulative filler are AlN (aluminum nitride), BN (boron nitride), MgSiN₂ (magnesium silicon nitride), SiC (silicon carbide), ceramic-coated graphite, or the like, or a combination comprising at least one of the foregoing high thermally conductive, electrically insulative fillers.

In one embodiment, one or more high thermally conductive, electrically conductive fillers can be used. The high thermally conductive, electrically conductive filler has an intrinsic thermal conductivity greater than or equal to 50 W/mK and, in one embodiment, has an electrical resistivity less than or equal to 1 Ohm.cm. Examples of the high thermally conductive, electrically conductive filler are graphite, expanded graphite, graphene, carbon fiber, carbon nanotubes (CNT), or graphitized carbon black, or the like, or a combination comprising at least one of the foregoing high thermally conductive, electrically conductive fillers. In one embodiment, even when electrically conductive fillers are added to the thermally conductive composition, the thermally conductive composition is not rendered electrically conducting, i.e., it is electrically insulating. In another embodiment, the thermally conducting composition may be electrically conducting.

In yet another embodiment, thermally insulating fillers with thermal conductivity lower than 10 W/mK, can be used. These include CaCO₃ (calcium carbonate), mica, BaO (barium oxide), BaSO₄ (barium sulfate), CaSiO₃ (wollastonite), ZrO₂ (zirconium oxide), SiO₂ (silicon oxide), glass beads, glass fiber, MgO•xAl₂O₃ (magnesium aluminate), CaMg(CO₃)₂ (dolomite), H₂Mg₃(SiO₃)₄ (talc), ceramic-coated graphite, or a clay; or the like, or a combination comprising at least one of the foregoing thermally insulating fillers.

In one embodiment, one or more of the foregoing thermally conductive fillers can be simultaneously added to the thermally conductive composition. In yet another embodiment, all of the foregoing thermally conductive fillers can be simultaneously added to the thermally conductive composition.

In one embodiment, fillers and reinforcing agents can be in the shape of particles, flakes or fibers. The fibers can have a circular or non-circular cross section and have an aspect ratio greater than 1. The fillers and reinforcing agents may be present in the composition in an amount of 0 to 60 wt%, specifically 5 to 50 wt%, more specifically 10 to 40 wt%, based on the total weight of the thermally conductive composition.

In addition, the thermally conductive compositions may optionally comprise a pigment, a dye, a colorant, or a combination thereof. Suitable pigments include for example, inorganic pigments such as metal oxides and mixed metal oxides such as zinc oxide, titanium dioxides, BaSO₄, CaCO₃, BaTiO₃, iron oxides or the like; sulfides such as zinc sulfides, or the like; aluminates; sodium sulfo-silicates; sulfates and chromates; carbon blacks; zinc ferrites; ultramarine blue; Pigment Brown 24; Pigment Red 101; Pigment Yellow 119; Pigment black 28; organic pigments such as azos, di-azos, quinacridones, perylenes, naphthalene tetracarboxylic acids, flavanthrones, isoindolinones, tetrachloroisoindolinones, anthraquinones, anthanthrones, dioxazines, phthalocyanines, and azo lakes; Pigment Blue 60, Pigment Red 122, Pigment Red 149, Pigment Red 177, Pigment Red 179, Pigment Red 202, Pigment Violet 29, Pigment Blue 15, Pigment Green 7, Pigment Yellow 147, Pigment Yellow 150, or the like, or a combination comprising at least one of the foregoing pigments. Pigments are generally used in amounts of 1 to 10 parts by weight, based on 100 parts by weight of the thermally conductive composition.

Suitable dyes include, for example, organic dyes such as coumarin 460 (blue), coumarin 6 (green), nile red or the like; lanthanide complexes; hydrocarbon and substituted hydrocarbon dyes; polycyclic aromatic hydrocarbons; scintillation dyes (preferably oxazoles and oxadiazoles); aryl- or heteroaryl-substituted poly (2-8 olefins); carbocyanine dyes; phthalocyanine dyes and pigments; oxazine dyes; carbostyryl dyes; porphyrin dyes; acridine dyes; anthraquinone dyes; arylmethane dyes; azo dyes; diazonium dyes; nitro dyes; quinone imine dyes; tetrazolium dyes; thiazole dyes; perylene dyes, perinone dyes; bis-benzoxazolylthiophene (BBOT); and xanthene dyes; fluorophores such as anti- stokes shift dyes which absorb in the near infrared wavelength and emit in the visible wavelength, or the like; luminescent dyes such as 5-amino-9-diethyliminobenzo(a)phenoxazonium perchlorate; 7-amino-4-methylcarbostyryl; 7-amino-4-methylcoumarin; 3-(2'-benzimidazolyl)-7-N,N-diethylaminocoumarin; 3-(2'-benzothiazolyl)-7-diethylaminocoumarin; 2-(4-biphenylyl)-5-(4-t-butylphenyl)-1,3,4-oxadiazole; 2-(4-biphenyl)-6-phenylbenzoxazole-1,3; 2,5-Bis-(4-biphenylyl)-1,3,4-oxadiazole; 2,5-bis-(4-biphenylyl)-oxazole; 4,4'-bis-(2-butyloctyloxy)-p-quaterphenyl; p-bis(o-methylstyryl)-benzene; 5,9-diaminobenzo(a)phenoxazonium perchlorate; 4-dicyanomethylene-2-methyl-6-(p-dimethylaminostyryl)-4H-pyran; 1,1'-diethyl-2,2'-carbocyanine iodide; 3,3'-diethyl-4,4',5,5'-dibenzothiatricarbocyanine iodide; 7-diethylamino-4-methylcoumarin; 7-diethylamino-4-trifluoromethylcoumarin; 2,2'-dimethyl-p-quaterphenyl; 2,2-dimethyl-p-terphenyl; 7-ethylamino-6-methyl-4-trifluoromethylcoumarin; 7-ethylamino-4-trifluoromethylcoumarin; nile red; rhodamine 700; oxazine 750; rhodamine 800; IR 125; IR 144; IR 140; IR 132; IR 26; IR5; diphenylhexatriene; diphenylbutadiene; tetraphenylbutadiene; naphthalene; anthracene; 9,10-diphenylanthracene; pyrene; chrysene; rubrene; coronene; phenanthrene or the like, or a combination comprising at least one of the foregoing dyes. Any dyes are generally used in amounts of from 0.1 to 5 parts by weight, based on 100 parts by weight of the thermally conductive composition.

Suitable colorants include titanium dioxide, anthraquinones, perylenes, perinones, indanthrones, quinacridones, xanthenes, oxazines, oxazolines, thioxanthenes, indigoids, thioindigoids, naphthalimides, cyanines, xanthenes, methines, lactones, coumarins, bis-benzoxazolylthiophene (BBOT), napthalenetetracarboxylic derivatives, monoazo and disazo pigments, triarylmethanes, aminoketones, bis(styryl)biphenyl derivatives, or the like, or a combination comprising at least one of the foregoing colorants. Any colorants are generally used in amounts of from 0.1 to 5 parts by weight, based on 100 parts by weight of the thermally conductive composition.

In addition, the thermally conductive compositions may comprise various additives ordinarily incorporated in polymer compositions of this type. Mixtures of additives may be used. Such additives may be mixed at a suitable time during the mixing of the components for forming the composition. The one or more additives are included in the thermoplastic compositions to impart one or more selected characteristics to the thermally conductive compositions and any molded article made therefrom without materially affecting the properties of molded article contain the composition. Examples of additives that may be included are heat stabilizers, process stabilizers, antioxidants, light stabilizers, plasticizers, antistatic agents, mold releasing agents, UV absorbers, lubricants, flow promoters, chain extenders, branching agents, impact modifiers, silicone char forming agents, chain extenders, or a combination of one or more of the foregoing additives.

Suitable heat stabilizers comprise, for example, organo phosphites such as triphenyl phosphite, tris-(2,6-dimethylphenyl)phosphite, tris-(mixed mono-and dinonylphenyl)phosphite or the like; phosphonates such as dimethylbenzene phosphonate or the like, phosphates such as trimethyl phosphate, or the like, or a combination comprising at least one of the foregoing heat stabilizers. Heat stabilizers are generally used in amounts of 0.01 to 0.5 parts by weight based on 100 parts by weight of the total composition, excluding any filler.

Suitable antioxidants comprise, for example, organophosphites such as tris(nonyl phenyl)phosphite, tris(2,4-di-t-butylphenyl)phosphite, bis(2,4-di-t-butylphenyl)pentaerythritol diphosphite, distearyl pentaerythritol diphosphite or the like; alkylated monophenols or polyphenols; alkylated reaction products of polyphenols with dienes, such as tetrakis[methylene(3,5-di-tert-butyl-4-hydroxyhydrocinnamate)] methane, or the like; butylated reaction products of para-cresol or dicyclopentadiene; alkylated hydroquinones; hydroxylated thiodiphenyl ethers; alkylidene-bisphenols; benzyl compounds; esters of beta-(3,5-di-tert-butyl-4-hydroxyphenyl)-propionic acid with monohydric or polyhydric alcohols; esters of beta-(5-tert-butyl-4-hydroxy-3-methylphenyl)-propionic acid with monohydric or polyhydric alcohols; esters of thioalkyl or thioaryl compounds such as distearylthiopropionate, dilaurylthiopropionate, ditridecylthiodipropionate, octadecyl-3-(3,5-di-tert-butyl-4-hydroxyphenyl)propionate, pentaerythrityl-tetrakis[3-(3,5-di-tert-butyl-4-hydroxyphenyl)propionate, or the like; amides of beta-(3,5-di-tert-butyl-4-hydroxyphenyl)-propionic acid, or the like, or a combination comprising at least one of the foregoing antioxidants. Antioxidants are generally used in amounts of from 0.01 to 0.5 parts by weight, based on 100 parts by weight of the total thermally conductive composition, excluding any filler.

Suitable plasticizers comprise, for example, phthalic acid esters such as dioctyl-4,5-epoxy-hexahydrophthalate, tris-(octoxycarbonylethyl)isocyanurate, tristearin, epoxidized soybean oil, or the like, or a combination comprising at least one of the foregoing plasticizers. Plasticizers are generally used in amounts of 0.5 to 3.0 parts by weight, based on 100 parts by weight of the total thermally conductive composition, excluding any filler.

The thermally conductive composition may include antistatic agents. Examples of antistatic agents include glycerol monostearate, sodium stearyl sulfonate, sodium dodecylbenzenesulfonate, or the like, or a combination comprising at least one of the foregoing antistatic agents. In one embodiment, carbon fibers, carbon nanofibers, carbon nanotubes, carbon black, or a combination comprising at least one of the foregoing carbonaceous materials may be used as antistatic agents to render the thermally conductive composition electrostatically dissipative.

Suitable mold releasing agents comprise for example, metal stearate, stearyl stearate, pentaerythritol tetrastearate, beeswax, montan wax, paraffin wax, or the like, or combinations including at least one of the foregoing mold release agents. Mold releasing agents are generally used in amounts of 0.1 to 1.0 parts by weight, based on 100 parts by weight of the total thermally conductive composition, excluding any filler.

Suitable UV absorbers comprise for example, hydroxybenzophenones; hydroxybenzotriazoles; hydroxybenzotriazines; cyanoacrylates; oxanilides; benzoxazinones; 2- (2H-benzotriazol-2-yl)-4-(1,1,3,3-tetramethylbutyl)-phenol (CYASORB™ 5411); 2-hydroxy-4-n-octyloxybenzophenone (CYASORB™ 531); 2-[4,6-bis(2,4-dimethylphenyl)-1,3,5-triazin-2-yl]- 5-(octyloxy)-phenol (CYASORB™ 1164); 2,2'-(1,4-phenylene)bis(4H-3,1-benzoxazin-4-one) (CYASORB™ UV- 3638); 1,3-bis[(2-cyano-3,3-diphenylacryloyl)oxy]-2,2-bis[[(2-cyano-3, 3-diphenylacryloyl)oxy]methyl]propane (UVINUL™ 3030); 2,2'-(1,4-phenylene) bis(4H-3,1-benzoxazin-4-one); 1,3-bis[(2-cyano-3,3-diphenylacryloyl)oxy]-2,2-bis[[(2-cyano-3,3-diphenylacryloyl)oxy]methyl]propane; hindered amino light stabilizers (HALS), nano-size inorganic materials such as titanium oxide, cerium oxide, and zinc oxide, all with particle size less than 100 nanometers; or the like, or combinations including at least one of the foregoing UV absorbers. UV absorbers are generally used in amounts of 0.01 to 3.0 parts by weight, based on 100 parts by weight of the thermally conductive composition, excluding any filler.

Suitable lubricants comprise for example, fatty acid esters such as alkyl stearyl esters, e.g., methyl stearate or the like; mixtures of methyl stearate and hydrophilic and hydrophobic surfactants including polyethylene glycol polymers, polypropylene glycol polymers, and copolymers thereof e.g., methyl stearate and polyethylene-polypropylene glycol copolymers in a suitable solvent; fatty amides such as ethylene bis stearamide (EBS), or the like, or a combination comprising at least one of the foregoing lubricants. Lubricants are generally used in amounts of from 0.1 to 5 parts by weight, based on 100 parts by weight of the thermally conductive total composition, excluding any filler.

Suitable blowing agents comprise for example, low boiling halohydrocarbons and those that generate carbon dioxide; blowing agents that are solid at room temperature and when heated to temperatures higher than their decomposition temperature, generate gases such as nitrogen, carbon dioxide, ammonia gas, such as azodicarbonamide, metal salts of azodicarbonamide, 4,4' oxybis(benzenesulfonylhydrazide), sodium bicarbonate, ammonium carbonate, or the like, or a combination comprising at least one of the foregoing blowing agents. Blowing agents are generally used in amounts of from 1 to 20 parts by weight, based on 100 parts by weight of the total thermally conductive composition, excluding any filler.

Additionally, materials to improve flow and other properties may be added to the composition, such as low molecular weight hydrocarbon resins. Particularly useful classes of low molecular weight hydrocarbon resins are those derived from petroleum C₅ to C₉ feedstock that are derived from unsaturated C₅ to C₉ monomers obtained from petroleum cracking. Non-limiting examples comprise olefins, e.g. pentenes, hexenes, heptenes and the like; diolefins, e.g. pentadienes, hexadienes and the like; cyclic olefins and diolefins, e.g. cyclopentene, cyclopentadiene, cyclohexene, cyclohexadiene, methyl cyclopentadiene and the like; cyclic diolefin dienes, e.g., dicyclopentadiene, methylcyclopentadiene dimer and the like; and aromatic hydrocarbons, e.g. vinyltoluenes, indenes, methylindenes and the like. The resins can additionally be partially or fully hydrogenated. Hyperbranched polymers (e.g., dendrimers) are another class of additives that are known to improve flow. Non-limiting examples include hyperbranched polyesters such as BOLTORN® H20 and H30 or the hyperbranched polyester-amides sold under the trademark HYBRANE® and commercially available from DSM.

In one embodiment, silicone char forming agents may be added to the thermally conductive compositions. The silicone char forming agents may contain polysiloxanes. Examples of silicone char forming agents are polyalkylsiloxanes (e.g., polydimethylsiloxane). Chain extenders may also be added to the thermally conductive compositions when silicone char forming agents are added to the thermally conductive compositions. Silicone char forming agents may be added in amounts of 0.5 to 10 wt%, specifically 0.5 to 2.5 wt%, based on the total weight of the thermally conductive composition. Chain extenders may be added in amounts of 0.1 to 5 wt%, based on the total weight of the thermally conductive composition.

The thermally conductive compositions can be readily formed using methods that involve dispersing one or more fillers in a thermoplastic resin. The thermally conductive compositions can generally be processed by a melt compounding process or solution blending process.

There is no particular limitation on the method by which the thermally conductive compositions may be prepared. For example, the ingredients may be placed into an extruder with the thermoplastic resin to produce molding pellets. Alternatively, the ingredients may be mixed with a thermoplastic resin by dry blending, then either fluxed on a mill and comminuted, or extruded and chopped. Further, the ingredients may also be mixed with powder or granular thermoplastic resin and directly molded, e.g., by injection or transferred molding techniques.

The flame retardant fillers and char-forming agents and fillers or reinforcing agents and any other additives may first be dry blended together, then fed into an extruder from one or multi-feeders, or separately fed into extruder from one or multi-feeders. The organic polymer or any polymeric combination may be first dry blended with each other, or dry blended with any combination of foregoing mentioned fillers or additives, then fed into an extruder from one or multiple-feeders. The fillers may also be first processed into a masterbatch, then fed into the extruder. The ingredients may be fed into the throat of the extruder or into a side-feeder and then into the extruder.

The extruders used may have a single screw, multiple screws, intermeshing co-rotating or counter rotating screws, non-intermeshing co-rotating or counter rotating screws, reciprocating screws, screws with pins, screws with screens, barrels with pins, rolls, rams, helical rotors, or combinations including at least one of the foregoing. The melt blending of the composites involves the use of shear force, extensional force, compressive force, ultrasonic energy, electromagnetic energy, thermal energy or combinations including at least one of the foregoing forces or forms of energy.

The barrel temperature on the extruder during compounding can be set at the temperature where at least a portion of the organic polymer has reached a temperature greater than or equal to about the melting temperature if the resin is a semi-crystalline organic polymer, or the flow point (e.g., the glass transition temperature) if the resin is an amorphous resin.

The moldable thermally conductive composition including the foregoing mentioned organic polymer and the fillers may be subject to multiple blending and forming steps if desirable. For example, the moldable thermally conductive composition may first be extruded and formed into pellets. The pellets may then be fed into a molding machine where it may be formed into any desirable shape or product. Alternatively, the moldable thermally conductive composition emanating from a single melt blender may be formed into sheets or strands and subjected to post-extrusion processes such as annealing, uniaxial or biaxial orientation.

Solution blending may also be used to manufacture the moldable thermally conductive composition. The solution blending may also use additional energy such as shear, compression, ultrasonic vibration, or the like, to promote homogenization of fillers with the organic polymer. In one embodiment, an organic polymer suspended in a fluid may be introduced into an ultrasonic sonicator along with any foregoing fillers. The mixture may be solution blended by sonication for a time period effective to disperse the fillers into the organic polymers. The organic polymer along with the fillers may then be dried, extruded and molded if desired.

The thermally conductive compositions can be formed into moldable stock material or moldable articles using techniques known to those in the art.

Flame retardancy was performed in accordance with UL-94 guidelines on calibrated equipment. These are detailed below. Thermal conductivity, (κ, W/m-K), is measured by either Nanoflash or Hotdisk equipment. The Nanoflash LFA447 method is using a pyroceram reference with similar thickness. The measurement determines the thermal diffusivity and the specific heat (Cp, J/g-K) of the sample, together with the density, which is measured using a water immersion method (ASTM D792), the product of three value gives the thermal conductivity in the through plane direction and in plane direction, according to: κ = α(T) Cp(T) p(T). A Hotdisk TPS2500 apparatus equipped with a 6mm radius sensor was used in the anisotropic mode, yielding the through-plane and in-plane thermal conductivity. The specific heat needed as input parameter for the anisotropic measurement was measured on the specific heat module using the same Hotdisk TPS 2500 apparatus. All measurements were performed under controlled conditions (23°C and 50% RH).

The thermally conductive compositions can be formed into an article of manufacture. In one embodiment the article can be a molded article. In one embodiment, the thermally conductive compositions and articles herein can be used in heat or thermal dissipation management applications where electrical insulation is desired. Examples comprise, but are not limited to, heat sinks for electronic components in computers and consumer electrical appliances, solar cells and batteries such as processors, lamps, LED-lamps, electric motors, electric circuits, the encapsulation of electronics, such as coils or casings, solar cell back sheets, battery casings, or the manufacture of heat exchangers for highly problematic (corrosive) environments.

Flammability tests were performed following the procedure of Underwriter's Laboratory Bulletin 94 entitled "Tests for Flammability of Plastic Materials, UL 94". Several ratings can be applied based on the rate of burning, time to extinguish, ability to resist dripping, and whether or not drips are burning. Samples for testing are bars having dimensions of 125 mm length×13 mm width by no greater than 13 mm thickness. Bar thicknesses varied from 1.6 mm to 0.8 mm. Materials can be classified according to this procedure as UL 94 HB (horizontal burn), V-0, V-1, V-2, 5VA and/or 5VB on the basis of the test results obtained for five samples; however, the compositions herein were tested and classified only as V-0, V-1, and V-2, the criteria for each of which are described below.

V-0: In a sample placed so that its long axis is 180 degrees to the flame, the period of flaming and/or smoldering after removing the igniting flame does not exceed ten (10) seconds and the vertically placed sample produces no drips of burning particles that ignite absorbent cotton. Five bar flame out time is the flame out time for five bars, each lit twice, in which the sum of time to flame out for the first (t1) and second (t2) ignitions is less than or equal to a maximum flame out time (t1+t2) of 50 seconds.

V-1: In a sample placed so that its long axis is 180 degrees to the flame, the period of flaming and/or smoldering after removing the igniting flame does not exceed thirty (30) seconds and the vertically placed sample produces no drips of burning particles that ignite absorbent cotton. Five bar flame out time is the flame out time for five bars, each lit twice, in which the sum of time to flame out for the first (t1) and second (t2) ignitions is less than or equal to a maximum flame out time (t1+t2) of 250 seconds.

V-2: In a sample placed so that its long axis is 180 degrees to the flame, the average period of flaming and/or smoldering after removing the igniting flame does not exceed thirty (30) seconds, but the vertically placed samples produce drips of burning particles that ignite cotton. Five bar flame out time is the flame out time for five bars, each lit twice, in which the sum of time to flame out for the first (t1) and second (t2) ignitions is less than or equal to a maximum flame out time (t1+t2) of 250 seconds.

The thermally conductive compositions have a flame retardancy of V-0, V-1, or V-2 or non-rated, at various thicknesses when tested according to the UL-94 protocol. The sample thickness can be 0.1 millimeter or less, 0.3 millimeter or less, specifically 0.4 millimeter or less, specifically 0.8 millimeter or less, specifically 1.0 mm or less, specifically 1.2 mm or less, specifically 1.5 mm or less, specifically 1.8 mm or less, specifically 2.0 mm or less, specifically 3.0 mm or less.

In one embodiment, the flame retardant composition has a flame retardancy of V-0 at a thickness of 0.8 millimeters or less when measured as per UL-94 protocol. In another embodiment, the flame retardant composition has a flame retardancy of V-0 at a thickness of 1.0 millimeters or less when measured as per UL-94 protocol. In yet another embodiment, the flame retardant composition has a flame retardancy of V-0 at a thickness of 1.2 millimeters or less when measured as per UL-94 protocol. In yet another embodiment, the flame retardant composition has a flame retardancy of V-0 at a thickness of 1.6 millimeters or less when measured as per UL-94 protocol.

The present invention is further illustrated by the following examples.

### EXAMPLES

### Example 1

Table 1 below provides a general description of the materials used in this example. This example was conducted to demonstrate the effect of metal hydroxides and polymeric char forming agents on the flame retardancy and thermal conductivity of the thermally conductive composition.

**Table 1**

| COMPONENT | Chemical description | Source |
|---|---|---|
| MAGNIFIN H-5 IV | Mg(OH)2 [CAS: 1309-42-8] | Martinswerk |
| PPG 3540 1/8" | Glass Fiber (GF) [CAS: 65997-17-3] | PPG |
| ULTRAMID B27 | Nylon 6 (PA6) [CAS: 25038-54-4] | BASF |
| PPO | PPE [CAS:25134-01-4] | Sabic Innovative Plastics |
| ULTEM 1010 | PEI [CAS: 61128-46-9] | Sabic Innovative Plastics |
| Domamid 24 | Nylon 6 (PA6) [CAS: 25038-54-4] (IV=2.4) | Domo |
| TECHNYLSTAR XS 1352 BL | Nylon 6 (PA6) [CAS: 25038-54-4] (IV=2.1) | Rhodia |
| Polyphenylene ether/Nylon 6 | Masterbatch made in-house at Sabic Innovative Plastics | Sabic Innovative Plastics |
| Polyphenylene ether/Nylon 66 | Masterbatch made in-house at Sabic Innovative Plastics | Sabic Innovative Plastics |
| Ultem 1040A (50%)/PA6 MB | Masterbatch made in-house at Sabic Innovative Plastics | Sabic Innovative Plastics |
| GF 3660 | Glass Fiber (GF) [CAS: 9003-56-9] | PPG |
| PETS | pentaerythritol tetrastearate [CAS: 115-83-3 | Lonza |
| Irganox 1098 | N,N'-Hexamethylene bis (3,5-di-t-butyl-4-hydroxyhydrocinnamamide) [CAS:23128-74-7] | Ciba |
| Irgafos 168 | Tris(di-t-butylphenyl)phosphite, secondary antioxidant [CAS:31570-04-4] | Ciba |
| Timrex KS150 | Graphite [CAS: 7782-42-5] | Timcal |
| Grade 2012 graphite | Graphite [CAS: 7782-42-5] | Asbury |

Tables 2 and 3 show the set temperatures used during the compounding and molding operations. The extrusion was conducted on a twin screw extruder having 10 barrels and a die. Extrusion conditions are shown in the Table 2.

**Table 2**

| Set temperatures | | |
|---|---|---|
| Intake Zone Temp | °C | 50 |
| Zone 1 Temp (intake) | °C | 150 |
| Zone 2 Temp | °C | 220 |
| Zone 3 Temp | °C | 250 |
| Zone 4 Temp | °C | 260 |
| Zone 5 Temp | °C | 260 |
| Zone 6 Temp | °C | 260 |
| Zone 7 Temp | °C | 260 |
| Zone 8 Temp | °C | 260 |
| Zone 9 Temp | °C | 265 |
| Zone 10 Temp | °C | 270 |
| Zone 11 Temp (die) | °C | 255 |
| Screw Speed | rpm | 300 |

Molding conditions are shown in the Table 3 below. Comparative Example 3 (C3) and Sample Nos. #3 - #5, were molded under one set of conditions shown below, while the remaining samples were molded according to another set of conditions as shown below in the Table 3.

**Table 3**

| | | All UL-bars and discs except discs (C3), #3 - #4 | Discs: C3, #3 - #4 |
|---|---|---|---|
| Drying time | (hrs) | 4 | 4 |
| Drying temperature | (°C) | 80 | 80 |
| T hopper | (°C) | 40 | 40 |
| T zone 1 | (°C) | 270 | 255 |
| T zone 2 | (°C) | 280 | 265 |
| T zone 3 | (°C) | 290 | 275 |
| T nozzle | (°C) | 295 | 270 |
| T mold | (°C) | 90 | 90 |

Tables 4 and 5 show the effect of polymer char forming agents on the flame properties and the thermal conductivity of the thermally conductive compositions. The PA-PPO compatibilized masterbatch (49.4% PP, 49.4% PA6, 0.9% citric acid and 0.3% Irganox 1010)) was made according to the invention described in US 2010/0081731 to Sai-Pei Ting. Test parts were injection molded on an Engel 70T-molding according to the conditions displayed in Table 3. Different molds were used, including UL-bars of different thicknesses and 3 mm thick disks with a diameter of 85 mm. Sample #s 1-5 and Comparative example C2 and C3 are included to demonstrate the unique performance of the compositions in the sense that the flame-retardancy for the samples of the invention outperforms the flame retardancy of the comparative examples. At similar magnesium hydroxide loadings, the addition of (or better exchanging a small part of the polyamide 6 for) small amounts of either polyphenylene ether (PPO) (Table 4) or polyetherimide (PEI) (Table 5) improved the flammability performance from V-0 at 1.6mm (borderline) to a solid V-0 performance at 1.2 or 1.0 mm thickness, with a relative small effect on thermal conductivity.

**Table 4**

| | | Example | Comparative Composition (C1) | #1 | #2 |
|---|---|---|---|---|---|
| | | | | 5wt% PPO | 7.5wt% PPO |
| | | | | | |
| | | DOMAMID24 | 37.100 | 26.980 | 21.920 |
| | | PPO/PA6 (49.4%PPO) MB | | 10.120 | 15.180 |
| | | Magnifin H-5 IV | 52.000 | 52.000 | 52.000 |
| | | GF 3660 | 10.000 | 10.000 | 10.000 |
| | | PETS | 0.500 | 0.500 | 0.500 |
| | | Irganox 1098 | 0.200 | 0.200 | 0.200 |
| | | Irgafos 168 | 0.200 | 0.200 | 0.200 |
| | | Total | 100% | 100% | 100% |

| Properties | | | | | |
|---|---|---|---|---|---|
| FLAME CHARACTERISTICS | Unit | Standard | Value | Value | Value |
| UL-94, V0/1.6mm | | UL-94 | pass | NM | NM |
| UL-94, VO/1.2mm | | UL-94 | fail | NM | NM |
| UL-94, V0/1.0mm | | UL-94 | fail | pass | pass |
| THERMAL | Unit | Standard | Value | Value | Value |
| Thermal Conductivity -Hotdisk (100*3mm discs) through-plane | W/mK | ISO 22007-2 | | 0.97 | 0.86 |
| Thermal Conductivity -Hotdisk (100*3mm discs) in-plane | W/mK | ISO 22007-2 | | 1.14 | 1.11 |

**Table 5**

| | | Composition | Comparative example | +2.5% Ultem 1010 | +5% Ultem 1010 | +7.5% Ultem 1010 |
|---|---|---|---|---|---|---|
| | | | (C3) | #3 | #4 | #5 |
| | | Domamid 24 | 36.60 | 34.10 | 31.60 | 29.10 |
| | | ULTEM 1010 | | 2.50 | 5.00 | 7.50 |
| | | Magnifin H5 IV | 45.10 | 45.10 | 45.10 | 45.10 |
| | | Asbury 2012 graphite | 17.45 | 17.45 | 17.45 | 17.45 |
| | | PETS | 0.50 | 0.50 | 0.50 | 0.50 |
| | | Irganox 1098 | 0.20 | 0.20 | 0.20 | 0.20 |
| | | Irgafos 168 | 0.15 | 0.15 | 0.15 | 0.15 |
| | | Total | 100% | 100% | 100% | 100% |

| Properties | | | | | | |
|---|---|---|---|---|---|---|
| FLAME CHARACTERISTICS | Unit | Standard | Value | Value | Value | Value |
| UL-94, V0/1.6mm | | UL-94 | pass | NM | NM | NM |
| UL-94, VO/1.2mm | | UL-94 | fail (V2) | pass | pass | pass |
| THERMAL | Unit | Standard | Value | Value | Value | Value |
| Thermal Conductivity -Hotdisk (100*3mm discs) through-plane | W/mK | ISO 22007-2 | 1.46 | 1.31 | 1.41 | 1.31 |
| Thermal Conductivity -Hotdisk (100*3mm discs) in-plane | W/mK | ISO 22007-2 | 4.18 | 5.02 | 3.43 | 4.27 |

The thermally conductive compositions of the Tables 4 and 5 display a thermally conductivity of 0.5 to 6.0 W/mK, specifically 1.0 to 5.0 W/mK, while at the same time displaying a flame retardancy of V-0 at thicknesses of 1.6 millimeters or less, specifically 1.5 millimeter or less when tested as per a UL-94 protocol.

The Tables 6 and 7 show the thermally conductive compositions along with properties. Both comparative and inventive thermally conductive compositions are included in these tables. As can be seen in the Table 6, polyarylene ether (polyphenylene ether (PPO)) is used as the polymeric char forming agent in amounts of 1.25 to 5 wt%, based on the total weight of the thermally conductive composition. The phenylene ether was introduced into the compositions in the form of a blend masterbatch with nylon 6 (PA6) and nylon66 (PA66). As can be seen from the Table 6, the inventive compositions contain between 46 to 53 weight percent of the metal hydroxide. From the Table 6, it may be seen that the comparative composition that does not contain the polymeric char forming agent fails to display flame retardancy (even though it contains over 46 wt% of the metal oxide), while the disclosed compositions show a flame retardancy of V-0 at 0.8 millimeters and thermal conductivity of 1 to 5 W/mK.

In the Table 7, the polymeric char forming agent was a polyetherimide (ULTEM 1040A) that was blended with a polyamide (Nylon 6). Comparative examples 5 and 6 (C5) and (C6) did not contain the polymeric char forming agent. In these examples too, the metal hydroxide was added in amounts of 46 to 53 wt%, based on the total weight of the composition.

From the data in the Table 7, it may be seen that the compositions that contain the polymeric char forming agent display flame retardancy in addition to thermal conductivity, while the comparative compositions (C5 and C6), both display thermal conductivity without flame retardancy. The disclosed compositions display a flame retardancy of V-0 at 0.8 millimeters and 1.2 millimeters when tested as per a UL-94 protocol, while the comparative compositions do not.

**Table 6**

| | | Example | | | | | | | | | | | | | |
|---|---|---|---|---|---|---|---|---|---|---|---|---|---|---|---|
| | | | Comparative example | 2.5 wt% PPO | 5 wt% PPO | 5 wt% PPO | 1.25 wt% PPO | 1.25 wt% PPO | 2.5wt% PPO | 1.25 wt% PPO | 2.5wt% PPO | 1.25 wt% PPO | 2 wt% PPO | 2.5 wt% PPO | 2.5 wt% PPO |
| | | | C4 | #6 | #7 | #8 | #9 | #10 | #11 | #12 | #13 | #14 | #15 | #16 | #17 |
| | | DOMAMID24 | 36.550 | 31.340 | 26.230 | 29.490 | 32.000 | 33.110 | 31.720 | 33.170 | 31.850 | 32.92 | 32.15 | 31.60 | 32.55 |
| | | PPO/PA6 (49.4%PPO) MB | | 5.060 | 10.120 | 5.060 | 2.500 | | | | | | | | |
| | | PPO/PA6 (89.94% PPO) | | | | | | 1.390 | 2.780 | | | | | | |
| | | PPO/PA6 MB (94.3%PPO) | | | | | | | | 1.330 | 2.650 | | | | |
| | | PPO/P A66 MB (95% PPO) | | | | | | | | | | 1.33 | 2.10 | 2.65 | 2.65 |
| | | Magnifin H-5 IV | 46.450 | 46.600 | 46.700 | 52.600 | 52.600 | 52.600 | 52.600 | 52.600 | 52.600 | 52.600 | 52.600 | 52.600 | 51.000 |
| | | Graphite | 16.150 | 16.150 | 16.100 | 12.000 | 12.000 | 12.000 | 12.000 | 12.000 | 12.000 | 12.000 | 12.000 | 12.000 | 12.650 |
| | | PETS | 0.500 | 0.500 | 0.500 | 0.500 | 0.500 | 0.500 | 0.500 | 0.500 | 0.500 | 0.500 | 0.500 | 0.500 | 0.500 |
| | | Irganox 1098 | 0.200 | 0.200 | 0.200 | 0.200 | 0.200 | 0.200 | 0.200 | 0.200 | 0.200 | 0.200 | 0.200 | 0.200 | 0.200 |
| | | Irgafos 168 | 0.150 | 0.150 | 0.150 | 0.150 | 0.200 | 0.200 | 0.200 | 0.200 | 0.200 | 0.150 | 0.150 | 0.150 | 0.150 |
| | | Waxoline BLK | | | | | | | | | | 0.300 | 0.300 | 0.300 | 0.300 |
| | | Total | | 100% | 100% | 100% | 100% | 100% | 100% | 100% | 100% | 100% | 100% | 100% | 100% |

| Properties | | | | | | | | | | | | | | | |
|---|---|---|---|---|---|---|---|---|---|---|---|---|---|---|---|
| FLAME CHARACTERISTICS | Unit | Standard | | Value | Value | | | Value | Value | Value | Value | Value | Value | Value | Value |
| UL-94, V-0@1.2mm | | UL-94 | fail | NM | NM | NM | NM | NM | NM | NM | NM | NM | NM | NM | NM |
| UL-94 V-0@1.0mm | | UL-94 | fail (NR) | NM | NM | NM | pass | NM | NM | NM | NM | NM | NM | NM | NM |
| UL-94, V-0@0.8mm | | UL-94 | fail (NR) | pass | pass | pass | fail (V2) | pass | pass | pass | pass | pass | pass | pass | pass |
| THERMAL | Unit | Standard | | Value | Value | Value | Value | Value | Value | Value | Value | Value | Value | Value | Value |
| Thermal Conductivity -Hotdisk (100*3mm discs) through-plane | W/mK | ISO 22007-2 | 1.58 | 1.45 | 1.33 | 1.44 | 1.16 | 1.18 | 1.09 | 1.13 | 1.08 | 1.52 | 1.46 | 1.42 | 1.41 |
| Thermal Conductivity -Hotdisk (100*3mm discs) in-plane | W/mK | ISO 22007-2 | 3.51 | 3.60 | 3.67 | 3.31 | 3.59 | 4.03 | 3.68 | 3.71 | 3.82 | 3.24 | 3.44 | 3.02 | 2.79 |

**Table 7**

| | | | Comparative example | +2.5% Ultem 1040A | +2.5% Ultem 1040A | Comparative example | +2.5% Ultem 1040A | +2.5% Ultem 1040A | +5% Ultem 1040A |
|---|---|---|---|---|---|---|---|---|---|
| | | | C5 | #18 | #19 | C6 | #21 | #22 | #23 |
| | | Domamid 24 | 34.55 | 29.49 | 29.49 | 36.55 | 31.34 | 6.50 | 26.23 |
| | | TECHNYLSTAR XS 1352 BL (IV=2.1) | | | | | | 24.84 | |
| | | ULTEM 1040A(50%)/PA6 MB | | 5.06 | 5.06 | | 5.06 | 5.06 | 10.12 |
| | | Magnifin H5 IV | 52.60 | 52.60 | 52.60 | 46.45 | 46.60 | 46.60 | 46.70 |
| | | Asbury 2012 graphite | 12.00 | 12.00 | | 16.15 | 16.15 | 16.15 | 16.1 |
| | | Timrex KS150 | | | 12.00 | | | | |
| | | PETS | 0.50 | 0.50 | 0.50 | 0.50 | 0.50 | 0.50 | 0.50 |
| | | Irganox 1098 | 0.20 | 0.20 | 0.20 | 0.20 | 0.20 | 0.20 | 0.20 |
| | | Irgafos 168 | 0.15 | 0.15 | 0.15 | 0.15 | 0.15 | 0.15 | 0.15 |
| | | Total | 100% | 100% | 100% | 100% | 100% | 100% | 100% |

| Properties | | | | | | | | | |
|---|---|---|---|---|---|---|---|---|---|
| FLAME CHARACTERISTICS | Unit | Standard | Value | Value | Value | Value | Value | Value | Value |
| UL-94, V-0 @ 1.2mm | | UL-94 | fail (V2) | NM | NM | fail (V2) | NM | NM | NM |
| UL-94, V-0 @ 1.0mm | | UL-94 | fail (NR) | pass | NM | fail (V2) | pass | pass | pass |
| UL-94, V-0 @ 0.8mm | | UL-94 | fail (NR) | pass | pass | fail (V2) | fail (V2) | pass | pass |
| THERMAL | Unit | Standard | Value | Value | Value | Value | Value | Value | Value |
| Thermal Conductivity -Hotdisk (100*3mm discs) through-plane | W/mK | ISO 22007-2 | 1.32 | 1.21 | 1.30 | 1.32 | 1.32 | 1.25 | 1.15 |
| Thermal Conductivity -Hotdisk (100*3mm discs) in-plane | W/mK | ISO 22007-2 | 3.30 | 3.77 | 3.64 | 3.91 | 3.81 | 3.47 | 4.01 |

## Claims

1. A thermally conductive composition, comprising:
20 to 80 wt% of a thermoplastic or thermosetting polymer;
10 to 70 wt% of a metal hydroxide;
5 to 60 wt% of a filler or a reinforcing agent, or a combination comprising at least one of the foregoing; and
0.5 to 10 wt% a polymeric char forming agent, where the polymeric char forming agent is a poly(arylene ether), a polyetherimide, a polyetherimide/polyimide copolymer, a polycarbonate, a polysulfone, a polyethersulfone, a polyetheretherketone, a polyetherketone, a polyketone, or a combination comprising at least one of the foregoing polymeric char-forming agents, and wherein the polymeric char forming agent provides the thermally conductive composition with a flame retardancy of V-0 at a thickness of 1.5 millimeter or less when tested as per a UL-94 testing protocol; and where the weight percents are based on a total weight of the thermally conductive composition.

2. The thermally conductive composition of claim 1, wherein the thermoplastic polymer is a polypropylene, a polyethylene, an ethylene based copolymer, a polyamide, a polyester, a polybutylene terephthalate, a polyethylene terephthalate, a polycyclohexylenedimethylene terephthalate, a polystyrene, a modified high impact polystyrene, a (meth)acryl polymer, a polyurethane, or a combination comprising at least one of the foregoing thermoplastic polymers.

3. The thermally conductive composition of any one of claims 1 and 2, wherein the metal hydroxide is Mg(OH)₂, γ-AlO(OH), α-AlO(OH), Al(OH)₃ or a combination comprising at least one of the foregoing metal hydroxides.

4. The thermally conductive composition of any one of claims 1 through 3, where the reinforcing agent comprises glass fibers.

5. The thermally conductive composition of any one of claims 1 through 4, wherein the filler or reinforcing agent has a thermal conductivity greater than or equal to 50 W/mK, and comprises AlN, Al₄C₃, Al₂O₃, BN, AlON, MgSiN₂, SiC, Si₃N₄, graphite, expanded graphite, graphene, carbon fiber, or a combination comprising at least one of the foregoing reinforcing agents; the filler or reinforcing agent has a thermal conductivity of 10 to 30 W/mK, and comprises ZnS, CaO, MgO, ZnO, TiO₂, or a combination comprising at least one of the foregoing reinforcing agents; or the filler or reinforcing agent has a thermal conductivity less than 10 W/mK, and comprises CaCO₃, mica, BaO, BaSO₄, CaSiO₃, ZrO₂, SiO₂, glass beads, glass fiber, MgO•xAl₂O₃, CaMg(CO₃)₂, H₂Mg₃(SiO₃)₄, ceramic-coated graphite, clay, or a combination comprising at least one of the foregoing reinforcing agents.

6. The thermally conductive composition of any one of claims 1 through 5, wherein the composition further comprises from 1 to 10% by weight of a pigment, a processing additive, or a combination comprising at least one of the foregoing additives.

7. The thermally conductive composition of any one of claims 1 and 3 through 9,wherein the thermosetting polymer is an epoxy polymer, an unsaturated polyester polymer, a polyimide polymer, a bismaleimide polymer, a bismaleimide triazine polymer, a cyanate ester polymer, a vinyl polymer, a benzoxazine polymer, a benzocyclobutene polymer, a (meth)acryl polymer, an alkyd polymer, a phenol-formaldehyde polymer, a novolac polymer, a resole polymer, a melamine-formaldehyde polymer, a urea-formaldehyde polymer, a hydroxymethylfuran polymer, an isocyanate polymer, a diallyl phthalate polymer, a triallyl cyanurate polymer, a triallyl isocyanurate polymer, an unsaturated polyesterimide, or a combination comprising at least one of the foregoing thermosetting polymers.

8. The thermally conductive composition of any one of claims 1 through 6, where the thermoplastic polymer is present in an amount of 20 to 50 wt%, based on the total weight of the thermally conductive composition and where the thermoplastic polymer is a polyamide, a polyester, or a polyolefin.

9. The thermally conductive composition of any one of claims 1 through 8, further comprising a silicone char forming agent.

10. The thermally conductive composition of any one of claims 1 through 9, further comprising a chain extender.

11. The thermally conductive composition of any one of claims 1, 5 and 8, wherein the thermally conductive composition has a thermal conductivity of at least 0.5 W/mK for through plane thermal conductivity.

12. An article comprising the composition of any one of claims 1 through 10.

13. A method comprising:
blending 20 to 80 wt% of a thermoplastic or thermosetting polymer; 10 to 70 wt% of a metal hydroxide; 0.5 to 2 wt% of an anti-flame dripping agent, 0.5 to 10 wt% of a polymeric char-forming agent, and 5 to 60 wt% of a filler or a reinforcing agent, or a combination comprising at least one of the foregoing,
wherein the polymeric char-forming agent is a poly(arylene ether), a polyetherimide, a polyetherimide/polyimide copolymer, a polycarbonate, a polysulfone, a polyethersulfone, a polyetheretherketone, a polyetherketone, a polyketone, or a combination comprising at least one of the foregoing polymeric char-forming agents, and wherein the thermally conductive composition has a thermal conductivity of at least 0.5 W/mK for through plane thermal conductivity; and a flame retardancy of at least V-0 performance at a thickness of 1.5 mm or less when tested as per a UL94 testing standard; where the weight percents are based on a total weight of the thermally conductive composition.

14. The method of claim 13, where the blending is effected in an extruder.

15. The method of any one of claims 13 and 14, further comprising molding the thermally conductive composition.

## Patentansprüche

1. Wärmeleitende Zusammensetzung, die Folgendes umfasst:
20 bis 80 Gew% eines thermoplastischen oder wärmehärtenden Polymers;
10 bis 70 Gew% eines Metallhydroxids;
5 bis 60 Gew% eines Füllstoffs oder eines Verstärkungsmittels oder einer Kombination, die mindestens eines der oben Angegebenen umfasst; und
0,5 bis 10 Gew% eines polymeren Kohlebildners, wobei der polymere Kohlebildner ein Poly(arylenether), ein Polyetherimid, ein Polyetherimid/Polyimidcopolymer, ein Polycarbonat, ein Polysulfon, ein Polyethersulfon, ein Polyetheretherketon, ein Polyetherketon, ein Polyketon oder eine Kombination ist, die mindestens einen der oben angegebenen polymeren Kohlebildner umfasst, und wobei der polymere Kohlebildner die wärmeleitende Zusammensetzung bereitstellt, mit einer Flammenfestigkeit von V-0 bei einer Dicke von 1,5 mm oder weniger, bei einem Test wie für ein UL-94-Testprotokoll; und wobei die Gewichtsprozente auf einem Gesamtgewicht der wärmeleitenden Zusammensetzung basieren.

2. Wärmeleitende Zusammensetzung nach Anspruch 1, wobei das thermoplastische Polymer ein Polypropylen, ein Polyethylen, ein Ethylenbasiertes Copolymer, ein Polyamid, ein Polyester, ein Polybutylenterephthalat, ein Polyethylenterephthalat, ein Polycyclohexylendimethylenterephthalat, ein Polystyren, ein modifiziertes hochschlagfestes Polystyren, ein (Meth)acrylpolymer, ein Polyurehtan oder eine Kombination ist, die mindestens eines der oben angegebenen thermoplastischen Polymere umfasst.

3. Wärmeleitende Zusammensetzung nach einem der Ansprüche 1 und 2, wobei das Metallhydroxid Mg(OH)₂, γ-AlO(OH), α-AlO(OH), Al(OH)₃ oder eine Kombination ist, die mindestens eines der oben angegebenen Metallhydroxide umfasst.

4. Wärmeleitende Zusammensetzung nach einem der Ansprüche 1 bis 3, wobei das Verstärkungsmittel Glasfasern umfasst.

5. Wärmeleitende Zusammensetzung nach einem der Ansprüche 1 bis 4, wobei der Füllstoff oder das Verstärkungsmittel eine Wärmeleitfähigkeit aufweist, die größer als oder gleich wie 50 W/mK ist und AlN, Al₄C₃, Al₂O₃, BN, AlON, MgSiN₂, SiC, Si₃N₄, Graphit, expandierten Graphit, Graphen, Kohlefaser oder eine Kombination umfasst, die mindestens eines der oben angegebenen Verstärkungsmittel umfasst; der Füllstoff oder das Verstärkungsmittel eine Wärmeleitfähigkeit von 10 bis 30 W/mK aufweist und ZnS, CaO, MgO, ZnO, TiO₂, oder eine Kombination umfasst, die mindestens eines der oben angegebenen Verstärkungsmittel umfasst; oder der Füllstoff oder das Verstärkungsmittel eine Wärmeleitfähigkeit von weniger als 10 W/mK aufweist und CaCO₃, Glimmer, BaO, BaSO₄, CaSiO₃, ZrO₂, SiO₂, Glaskügelchen, Glasfaser, MgO•xAl₂O₃, CaMg(CO₃)₂, H₂Mg₃(SiO₃)₄, Keramikbeschichteten Graphit, Ton oder eine Kombination umfasst, die mindestens eines der oben angegebenen Verstärkungsmittel umfasst.

6. Wärmeleitende Zusammensetzung nach einem der Ansprüche 1 bis 5, wobei die Zusammensetzung weiter von 1 bis 10 Gew% eines Pigments, eines Verarbeitungszusatzes oder einer Kombination umfasst, die mindestens eines der oben angegebenen Zusätze umfasst.

7. Wärmeleitende Zusammensetzung nach einem der Ansprüche 1 und 3 bis 9, wobei das wärmehärtende Polymer ein Epoxypolymer, ein ungesättigtes Polyesterpolymer, ein Polyimidpolymer, ein Bismaleimidpolymer, ein Bismaleimidtriazinpolymer, ein Cyanatesterpolymer, ein Vinylpolymer, ein Benzoxazinpolymer, ein Benzocyclobutenpolymer, ein (Meth)acrylpolymer, ein Alkydpolymer, ein Phenolformaldehydpolymer, ein Novolacpolymer, ein Resolpolymer, ein Melaninformaldehydpolymer, ein Harnstoff-Formaldehydpolymer, ein Hydroxymethylfuranpolymer, ein Isocyanatpolymer, ein Diallylphthalatpolymer, ein Triallylcyanuratpolymer, ein Triallylisocyanuratpolymer, ein ungesättigtes Polyesterimid, oder eine Kombination ist, die mindestens eines der oben angegebenen thermoplastischen Polymere umfasst.

8. Wärmeleitende Zusammensetzung nach einem der Ansprüche 1 bis 6, wobei das thermoplastische Polymer in einer Menge von 20 bis 50 Gew% vorhanden ist, basierend auf dem Gesamtgewicht der wärmeleitenden Zusammensetzung, und wobei das thermoplastische Polymer ein Polyamid, ein Polyester oder ein Polyolefin ist.

9. Wärmeleitende Zusammensetzung nach einem der Ansprüche 1 bis 8, die weiter einen Silikon-Kohlebildner umfasst.

10. Wärmeleitende Zusammensetzung nach einem der Ansprüche 1 bis 9, die weiter einen Kettenverlängerer umfasst.

11. Wärmeleitende Zusammensetzung nach einem der Ansprüche 1, 5 und 8, wobei die wärmeleitende Zusammensetzung eine Wärmeleitfähigkeit von mindestens 0,5 W/mK für Through-Plane-Wärmeleitfähigkeit aufweist.

12. Gegenstand, der die Zusammensetzung nach einem der Ansprüche 1 bis 10 umfasst.

13. Verfahren, das Folgendes umfasst:
Mischen von 20 bis 80 Gew% eines thermoplastischen oder wärmehärtenden Polymers; 10 bis 70 Gew% eines Metallhydroxids; 0,5 bis 2 Gew% eines flammenhemmenden Tropfmittels, 0,5 bis 10 Gew% eines polymeren Kohlebildners, und 5 bis 60 Gew% eines Füllstoffs oder eines Verstärkungsmittels oder eine Kombination, die mindestens eines der oben Angegebenen umfasst,
wobei der polymere Kohlebildner ein Poly(arylenether), ein Polyetherimid, ein Polyetherimid/Polyimidcopolymer, ein Polycarbonat, ein Polysulfon, ein Polyethersulfon, ein Polyetheretherketon, ein Polyetherketon, ein Polyketon oder eine Kombination ist, die mindestens eines der oben angegebenen polymeren Kohlebildner umfasst, und wobei die wärmeleitende Zusammensetzung eine Wärmeleitfähigkeit von mindestens 0,5 W/mK für Through-Plane-Wärmeleitfähigkeit aufweist; und eine Flammenfestigkeit mit einer Leistung von mindestens V-0 bei einer Dicke von 1,5 mm oder weniger bei einem Test wie für ein UL-94-Testprotokoll; wobei die Gewichtsprozente auf einem Gesamtgewicht der wärmeleitenden Zusammensetzung basieren.

14. Verfahren nach Anspruch 13, wobei das Mischen in einem Extruder erfolgt.

15. Verfahren nach einem der Ansprüche 13 und 14, weiter umfassend die Formung der wärmeleitenden Zusammensetzung.

## Revendications

1. Composition thermoconductrice comprenant :
20 à 80% en poids d'un polymère thermoplastique ou thermodurcissable ;
10 à 70% en poids d'un hydroxyde métallique ;
5 à 60% en poids d'une charge ou d'un agent de renforcement, ou une combinaison comprenant au moins l'un des éléments précédents ; et
0,5 à 10% en poids d'un agent de formation de charbon polymère, où l'agent de formation de charbon polymère est un poly(arylène éther), un polyétherimide, un copolymère de polyétherimide/polyimide, un polycarbonate, une polysulfone, une polyéthersulfone, une polyétheréthercétone, une polyéthercétone, une polycétone, ou une combinaison comprenant au moins l'un des agents de formation de charbon polymère précédents, et où l'agent de formation de charbon polymère fournit à la composition thermoconductrice une ininflammabilité de V-0 à une épaisseur inférieure ou égale à 1,5 millimètre lorsqu'elle est testée conformément à un protocole d'essai UL-94 ; et où les pourcentages en poids sont exprimés par rapport au poids total de la composition thermoconductrice.

2. Composition thermoconductrice de la revendication 1, dans laquelle le polymère thermoplastique est un polypropylène, un polyéthylène, un copolymère à base d'éthylène, un polyamide, un polyester, un polybutylène téréphtalate, un polyéthylène téréphtalate, un polycyclohexylènediméthylène téréphtalate, un polystyrène, un polystyrène choc modifié, un polymère (méth)acrylique, un polyuréthane ou une combinaison comprenant au moins l'un des polymères thermoplastiques précédents.

3. Composition thermoconductrice de l'une quelconque des revendications 1 et 2, dans laquelle l'hydroxyde métallique est Mg(OH)₂, γ-AlO(OH), α-AlO(OH), Al(OH)₃ ou une combinaison comprenant au moins l'un des hydroxydes métalliques précédents.

4. Composition thermoconductrice de l'une quelconque des revendications 1 à 3, dans laquelle l'agent de renforcement comprend des fibres de verre.

5. Composition thermoconductrice de l'une quelconque des revendications 1 à 4, dans laquelle la charge ou l'agent de renforcement présente une conductivité thermique supérieure ou égale à 50 W/mK, et comprend AlN, Al₄C₃, Al₂O₃, BN, AlON, MgSiN₂, SiC, Si₃N₄, du graphite, du graphite expansé, du graphène, une fibre de carbone ou une combinaison comprenant au moins l'un des agents de renforcement précédents ; la charge ou l'agent de renforcement présente une conductivité thermique allant de 10 à 30 W/mK, et comprend ZnS, CaO, MgO, ZnO, TiO₂ ou une combinaison comprenant au moins l'un des agents de renforcement précédents ; ou la charge ou l'agent de renforcement présente une conductivité thermique inférieure à 10 W/mK, et comprend CaCO₃, du mica, BaO, BaSO₄, CaSiO₃, ZrO₂, SiO₂, des billes de verre, une fibre de verre, MgO•xAl₂O₃, CaMg(CO₃)₂, H₂Mg₃(SiO₃)₄, du graphite revêtu de céramique, de l'argile ou une combinaison comprenant au moins l'un des agents de renforcement précédents.

6. Composition thermoconductrice de l'une quelconque des revendications 1 à 5, dans laquelle la composition comprend en outre 1 à 10% en poids d'un pigment, d'un additif de traitement ou d'une combinaison comprenant au moins l'un des additifs précédents.

7. Composition thermoconductrice de l'une quelconque des revendications 1 et 3 à 9, dans laquelle le polymère thermodurcissable est un polymère époxy, un polymère de polyester insaturé, un polymère de polyimide, un polymère de bismaléimide, un polymère de triazine de bismaléimide, un polymère d'ester de cyanate, un polymère vinylique, un polymère de benzoxazine, un polymère de benzocyclobutène, un polymère (méth)acrylique, un polymère alkyde, un polymère de phénol-formaldéhyde, un polymère novolaque, un polymère de type résol, un polymère de mélamine-formaldéhyde, un polymère d'urée-formaldéhyde, un polymère d'hydroxyméthylfurane, un polymère d'isocyanate, un polymère de phtalate de diallyle, un polymère de cyanurate de triallyle, un polymère d'isocyanurate de triallyle, un polyesterimide insaturé, ou une combinaison comprenant au moins l'un des polymères thermodurcissables précédents.

8. Composition thermoconductrice de l'une quelconque des revendications 1 à 6, dans laquelle le polymère thermoplastique est présent en une quantité allant de 20 à 50% en poids, par rapport au poids total de la composition thermoconductrice et où le polymère thermoplastique est un polyamide, un polyester ou une polyoléfine.

9. Composition thermoconductrice de l'une quelconque des revendications 1 à 8, comprenant en outre un agent de formation de charbon silicone.

10. Composition thermoconductrice de l'une quelconque des revendications 1 à 9, comprenant en outre un allongeur de chaîne.

11. Composition thermoconductrice de l'une quelconque des revendications 1, 5 et 8, dans laquelle la composition thermoconductrice présente une conductivité thermique d'au moins 0,5 W/mK pour la conductivité thermique à travers le plan.

12. Article comprenant la composition de l'une quelconque des revendications 1 à 10.

13. Procédé comprenant le fait :
de mélanger 20 à 80% en poids d'un polymère thermoplastique ou thermodurcissable ; 10 à 70% en poids d'un hydroxyde métallique ; 0,5 à 2% en poids d'un agent anti-égoutture de flamme, 0,5 à 10% en poids d'un agent de formation de charbon polymère, et 5 à 60% en poids d'une charge ou d'un agent de renforcement, ou une combinaison comprenant au moins l'un des éléments précédents,
dans lequel l'agent de formation de charbon polymère est un poly(arylène éther), un polyétherimide, un copolymère de polyétherimide/polyimide, un polycarbonate, une polysulfone, une polyéthersulfone, une polyétheréthercétone, une polyéthercétone, une polycétone ou une combinaison comprenant au moins l'un des agents de formation de charbon polymère précédents, et où la composition thermoconductrice présente une conductivité thermique d'au moins 0,5 W/mK pour la conductivité thermique à travers le plan ; et une ininflammabilité d'au moins une performance V-0 à une épaisseur inférieure ou égale à 1,5 mm lorsqu'elle est testée conformément à une norme d'essai UL94 ; où les pourcentages en poids sont exprimés par rapport au poids total de la composition thermoconductrice.

14. Procédé de la revendication 13, dans lequel le mélange est effectué dans une extrudeuse.

15. Procédé de l'une quelconque des revendications 13 et 14, comprenant en outre le fait de mouler la composition thermoconductrice.
